(19) Europäisches Patentamt

European Patent Office

Office européen des brevets

(11) EP 0 486 865 B1

(12) EUROPÄISCHE PATENTSCHRIFT

(45) Veröffentlichungstag und Bekanntmachung des Hinweises auf die Patenterteilung:
**31.01.1996 Patentblatt 1996/05**

(51) Int Cl.⁶: **H03L 7/093**

(21) Anmeldenummer: **91118773.0**

(22) Anmeldetag: **04.11.1991**

(54) **Phasenregelkreis höherer Ordnung**

Higher order phase locked loop

Boucle à verrouillage de phase d'ordre plus élevé

(84) Benannte Vertragsstaaten:
**CH DE GB IT LI NL**

(30) Priorität: **20.11.1990 DE 4036998**

(43) Veröffentlichungstag der Anmeldung:
**27.05.1992 Patentblatt 1992/22**

(73) Patentinhaber:
**SIEMENS AKTIENGESELLSCHAFT**
**D-80333 München (DE)**

(72) Erfinder:
• **Sebald, Georg**
  **W-8000 München 70 (DE)**

• **Lankl, Berthold, Dr.-Ing.**
  **W-8000 München 70 (DE)**
• **Nist, Alfred**
  **W-8082 Grafrath (DE)**

(56) Entgegenhaltungen:
EP-A- 0 149 803     US-A- 4 208 635
US-A- 4 788 512

• EDN ELECTRICAL DESIGN NEWS. Bd. 35, Nr. 17, 20. August 1990, NEWTON, MASSACHUSETTS US Seiten 141 - 149; FRED SALVATTI: 'TECHNIQUE EASES DESIGN OF PHASE-LOCKED LOOPS'
• ELECTRONICS LETTERS. Bd. 15, Nr. 13, Juni 1979, ENAGE GB Seiten 391 - 393; M. J. UNDERHILL ET AL.: 'SPLIT-LOOP METHOD FOR WIDE- RANGE FREQUENCY SYNTHESISER WITH GOOD DYNAMIC PERFORMANCE'

**Beschreibung**

Phasenregelkreis höherer Ordnung

Die Erfindung betrifft einen Phasenregelkreis höherer Ordnung mit automatischem Restfehlerabgleich gemäß dem Oberbegriff des Patentanspruchs 1.

Phasenregelkreise der vorgenannten Art sind aus dem Buch von F. Gardner, Phaselock-Techniques, Verlag John Wiley 1966, ISBN 0-471-04294-3, oder aus dem Buch von Roland Best, Theorie und Anwendungen des Phaselocked Loops, A.T.-Verlag, Aarau (Schweiz) 1981, ISBN 3-85502-123-6 bekannt.

Phasenregelkreise höherer Ordnung (0≥2), wie sie z. B. in vielstufigen QAM-Systemen zur Träger- und/oder Taktrückgewinnung verwendet werden, müssen einen sehr kleinen Regelrestfehler aufweisen, damit ein optimales Abtastfenster für die Signalentscheidung geschaffen wird. Aufgabe der Trägerrückgewinnung ist es beispielsweise, die Konstellationspunkte möglichst exakt auf ein quadratisches Muster zu positionieren. Liegt ein Abgleichfehler von nur 1 Grad vor, so degradiert bei einer Bitfehlerrate von 10exp-9 ein 64QAM-System bereits um 0.85 dB, ein 256 QAM-System um 2 dB. Im Falle des Taktregelkreises führt ein Regelfehler einerseits zu einem falsch gewählten Abtastzeitpunkt ("das Auge wird nicht getroffen"), was insbesondere bei Systemen ohne Zeitbereichsentzerrer sehr schnell störend wird, andererseits wird ein Regelrestfehler (Offset-problem) bei bestimmten Selektiv-Verzerrungen (z. B. Notch auf der Nyquistfrequenz) das Wiedereinrasten der Schleife verhindern.

Um diese Nachteile zu vermeiden, mußte bisher ein sehr genauer Offset-Abgleich des Phasendetektors und des Loopfilters, realisiert mit Hilfe von Operationsverstärkern, durchgeführt werden. Dieser Abgleich muß auch über Temperatur und Alterungstoleranzen stehen bleiben. Insbesondere bei Systemen mit kleinem Roll-off (Rho = 0.2) kann das zur Einführung von Temperaturkompensationen in den Schaltungen führen. Alterungseffekte können jedoch nicht in jedem Fall beseitigt werden.

Grundsätzlich ließen sich die obengenannten Nachteile mit volldigital realisierten Schaltungen vermeiden. Aufwandabschätzung vom schnellen, volldigitalen Trägerregelkreisen, ergeben jedoch zu hohe Kosten und lange Entwicklungszeiten.

Bei ausreichend geringer Verarbeitungsgeschwindigkeit ist eine digitale Realisierung in Signalprozessoren (DSP's) möglich.

Bei analoger Realisierung werden durch symmetrische Schaltungsauslegung, Temperaturkompensation und Präzisionsabgleich die Probleme reduziert. Das bekannte Problem des Restfehlers bei Frequenzversatz des rückgewonnenen Signals wurde wegen des bislang als unvermeidbar angesehenen ohmschen Widerstand in der Rückkopplung des Operationsverstärkers (Propotionalanteil) nicht grundsätzlich gelöst.

Der Erfindung liegt die Aufgabe zugrunde, einen Phasenregelkreis anzugeben, bei dem die vorstehend geschilderten Schwierigkeiten beseitigt sind.

Diese Aufgabe wird gemäß der Erfindung nach den kennzeichnenden Merkmalen des Patentanspruchs 1 gelöst.

Vorteilhafte Ausführungsformen sind in den Unteransprüchen angegeben.

Der statische Regelrestfehler von herkömmlichen, analog realierten Phasenregelkreisen höherer Ordnung (0 ≥ 2) hängt von Schaltungseigenschaften wie Bauelementetoleranzen, Offset, Temperaturdrift und Alterung einerseits sowie vom Frequenzversatz des rückgewonnenen Signals andererseits ab. Dies führt bei Phasenregelkreisen, wie sie z. B. bei höherstufigen QAM-Systemen zur Takt- und Trägerrückgewinnung verwendet werden, zu einer Reduktion des Abtastfensters bei der Signalentscheidung und damit des Systemgewinns.

Die erfindungsgemäße Schaltung gleicht bei laufendem Betrieb automatisch den Restfehler ab. Die obengenannten Probleme werden damit umgangen. Beim Prüfen der Schaltung ist keinerlei Abgleich erforderlich.

Es läßt sich also das angegebene Schaltungsprinzip grundsätzlich auf alle Phasenregelkreise anwenden, sofern ein binäres, also ein digitales Fehlerkriterium am Regelziel abgeleitet werden kann.

Anhand von Ausführungsbeispielen wird nachstehend die Erfindung noch näher erläutert.

Es zeigen:

Fig. 1      einen Phasenregelkreis 2. Ordnung, Standard-Schaltung
Fig. 2      eine Koeffizienten-Regelung mit Auto-Zero-Technik,
Fig. 3a     ein klassisches Loopfilter für Phasenregelkreis 2. Ordnung,
Fig. 3b     eine "zerlegte" Struktur des Loopfilters,
Fig. 4      ein komplettes Prinzipschaltbild des Phasenregelkreises mit automatischem Restfehlerabgleich,
Fig. 5      eine Trägerrückgewinnung,
Fig. 6      eine digitale Taktrückgewinnung,
Fig. 7      das Prinzip der ($\Sigma$-$\Delta$) D/A-Wandlung und
Fig. 8      die Kombination des ($\Sigma$-$\Delta$) - D/A-Wandler-Prinzip mit der Auto-Zerotechnik.

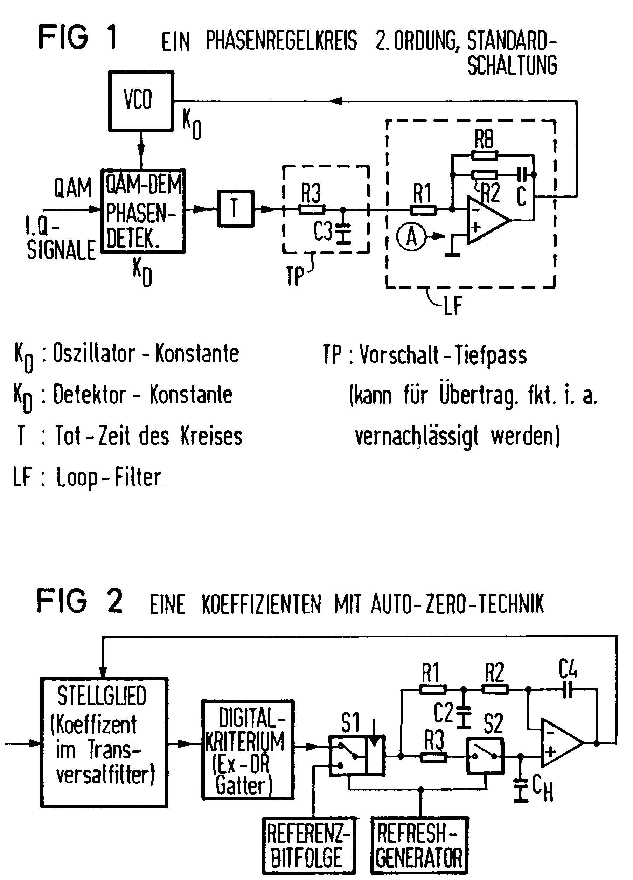

Figur 1 zeigt das an sich bekannte Schaltungsprinzip, wie es sinngemäß auch aus dem Buch F. Gardner, Phaselock-Techniques, Verlag John Wiley 1966, ISBN 0-471-04294-3 oder aus dem Buch R. Best, Theorie und Anwendungen des Phaselocked Loops, A.T.-Verlag, Aarau (Schweiz) 1981, ISBN 3-85502-123-6 bekannt ist.

Die in Figur 1 eingeführten Schaltsymbole, Bezeichnungen und Bezugshinweise werden in den folgenden Figuren mit der gleichen Bedeutung wiederverwendet.

In Figur 1 ist also zu erkennen ein spannungsgesteuerter Oszillator (VCO) der zur QAM-Demodulation erforderlich ist und einen Phasendetektor der die für die QAM-Demodulation, korrekte Phase ableitet. Die Eingangssignale sind gewissermaßen mit QAM bezeichnet, die dort in bekannter Weise in I, Q-Signale. unterteilt sind. Dem Phasendetektor folgt ein Laufzeitglied mit der Laufzeit T, es schließt sich an ein Tiefpaß (gestrichelt eingerahmt) TP und ein weiterer gestrichelt eingerahmter Schaltungsabschnitt, der als LF (Loop-filter) bezeichnet ist. Wie der Pfeil erkennen läßt, ist die Signalflußrichtung vom Ausgang des Loop-filters LF auf den Eingang des spannungsabhängigen Oszillators VCO, gekennzeichnet durch seine Oszillator-Konstante $K_0$, gerichtet. Der Tiefpaß TP, der für die gesamte Übertragungsfunktion im interessierenden Bereich im allgemeinen vernachlässigt werden kann, besteht aus einem Halbglied mit dem Serienwiderstand R3 dem in Richtung Erde (Masse) ein Kondensator C3 zugeschaltet ist. Im Loop-filter LF ist zu erkennen ein Operationsverstärker, dessen nicht inventierender Eingang (+) an Masse geschaltet ist und dessen invertierendem Eingang der Widerstand R1 vorgeschaltet ist und dessen Ausgang über die Parallelschaltung aus dem Widerstand R8 und die Serienschaltung aus dem Widerstand R2 und dem Kondensator C2 mit dem invertierenden Eingang (-) verbunden ist.

Figur 1 zeigt das prinzipielle Schaltbild eines Phasenregelkreises zweiter Ordnung, wie er bislang in QAM-Demodulatoren für Richtfunksysteme mit hoher Bandbreiteneffizienz realisiert wurde. Der Tiefpaß TP hat die Aufgabe, hochfrequente Spannungsspitzen vom nachfolgenden Operationsverstärker fernzuhalten. Aufgrund seiner relativ hohen Grenzfrequenz, verglichen mit der Grenzfrequenz des Loopfilters, geht er praktisch nicht in die Phasen-Übertragungsfunktion ein. In praktischer Anwendung werden zur Schaltungsstabilität die Teile LF und TP symmetrisch ausgeführt.

Die Totzeit T, die z.B. durch Laufzeit im Zeitbereichs-Entzerrer entsteht, ist in diesem Zusammenhang bedeutungslos. Sie ist nur der Vollständigkeit halber mitaufgeführt. Die Offset-Problematik der Gesamtschaltung läßt sich reduzieren auf eine einzige Offsetspannung, die am Punkt A eingeprägt ist. Diese Offsetspannung muß in der Praxis genau abgeglichen sein und ihren Wert über Temperatur und Zeit beibehalten.

Der Widerstand R8 ergibt einen Proportional-Regelanteil in der Übertragungsfunktion, der dann zu einem stationären Regelrestfehler führt, wenn die Frequenz des zu detektierenden Signals nicht der VCO-Mittenfrequenz entspricht. Er wird deshalb so groß wie möglich gemacht. Er ist allerdings für das Wiedereinrasten- z.B. nach Signalunterbrechungen - unumgänglich, da ohne ihn im ausgerasteten Zustand der Operationsverstärker auf Anschlag laufen und damit die für das Wiedereinrasten notwendigen Übertragungseigenschaften verlieren würde.

Die hier beschriebene neue Schaltung umgeht einerseits den Widerstand R8 und die damit verbundenen Probleme und besorgt andererseits einen automatischen kontinuierlichen Offsetabgleich bei laufendem Betrieb.

In Figur 2 ist der automatische Offset-Abgleich am Beispiel der Koeffizienten-Regelung eines adaptiven Zeitbereichsentzerrers mit Auto-Zero-Technik gezeigt. Zu erkennen ist ein Stellglied, dem ein Digital-Kritierium (Ex-Or Gatter) folgt, dessen Ausgang auf einen Schalter S1 führt. Einem zweiten Eingang des Schalters S1 wird zugeführt eine Referenzbitfolge. Ein Refreshgenerator steuert die Schalter S1 und S2. Zu erkennen ist ein Kondensator $C_H$, der einerseits an dem nichtinvertierenden Eingang eines Operationsverstärkers (Op-Amp) und andererseits an Masse liegt. Der Ausgang des Op-Amps ist rückgekoppelt über den Kondensator C4 und dort mit dem invertierenden Eingang des Op-Amps verbunden. Ein T-Glied mit den Widerständen R1, R2 und dem Kondensator C2 im Querzweig (Masse) überbrückt den Schalter S2. Dieses T-Glied führt eingangsseitig auf den dem Schalter S2 vorgeschalteten Widerstand R3. Der Ausgang des Op-Amps ist auf den Eingang des Stellgliedes geschaltet.

Ausgangspunkt der Überlegungen war das Patent "1 Bit/l Bit Digital-Korrelator mit selbständig einstellender Integrator-Referenzspannung" (EP 0149803). Sie liefert sehr präzise, reproduzierbare Einstellungen ohne Fertigungsprobleme. Figur 2 zeigt das Schaltungsprinzip. Eine Referenzbitfolge wird periodisch über den getakteten Schalter S1 in den vom digitalen Kriterium (Ex-Or-Gatter) kommenden Datenstrom (Ergebnisbitfolge) eingeblendet.

Sie hat den gleichen physikalischen Gleichspannungsmittelwert wie eine Ergebnisbitfolge, bei der Nullen und Einsen mit zufallsartiger Gleichverteilung auftreten. Die Referenzbitfolge wird periodisch über einen Vorwiderstand und S2 (bidirektionaler C-MOS-Schalter) auf einen Haltekondensator $C_H$ geschaltet, der unmittelbar am Referenz-Spannungseingang des Integrators (J-FET Op-Amp) liegt und der sich auf die Mittelwertspannung nur der Referenzfolge und nicht der Ergebnisbitfolge einstellt. Diese Mittelwertspannung stellt in praktisch idealer Weise die Referenz-Nullspannung des Integrators bei verschwundener Korrelation in der Ergebnisbitfolge dar und zwar unabhängig von physikalischen Pegeländerungen des Digitalsignals, Temperatur, Alterung und Anliefertoleranzen. Der Tiefpaß R1/C2 unterdrückt wiederum die hohen Frequenz anteile vor dem Op-Amp. R2/C4 bestimmen die Intergratorkonstante (gewählt wurde 1/0.5 ms) Die Regelschaltung stellt (bei Vernachlässigung von R1/C2) einen Regelkreis erster Ordnung dar. Die 3 dB Grenzfrequenz (closed loop bandwidth) liegt bei einigen Kilohertz. Sie ist ausreichend schnell zur Einstellung der Entzerrer-Koeffizienten.

Die direkte Übernahme des Schaltungsprinzips auf Phasen-Regelkreise.zweiter Ordnung, bei denen im Rückkopplungspfad des Op-Amps eine Serienschaltung von R und C liegt (z.B. für Trägerrückgewinnungsschaltungen) scheitert daran, daß hier die erforderliche 3 dB-Bandbreite deutlich höher sein müßte. Das periodische Einblenden der Referenzfolge würde vorübergehend die Regelung unterbrechen und die Einblendzeit kann nicht soweit verkürzt werden, daß dieser Effekt nicht mehr stören würde.

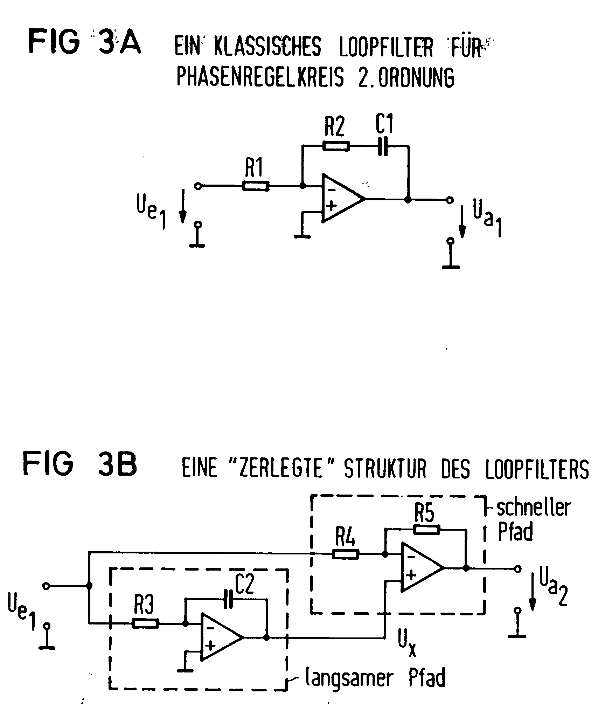

Deshalb wurde versucht, die Schaltung des Loopfilters (2. Ordnung) in einen schnellen und einen langsamen Pfad zu zerlegen, Figur 3A, Figur 3B.

Figur 3A ist als klassisches Loopfilter in Figur 1 wiederzuerkennen.

Figur 3B zeigt die zerlegte Struktur des Loopfilters. Es ist zu erkennen (gestrichelt eingerahmt) ein langsamer Pfad und ein (ebenfalls gestrichelt eingerahmt) schneller Pfad. Der Eingang ist mit $U_{e1}$ und der Ausgang mit $U_{a2}$ bezeichnet. Der langsame Pfad besteht aus einem Operationsverstärker, der über einen Kondensator C2 rückgekoppelt ist und dessen invertierendem Eingang der Widerstand R3 vorgeschaltet ist. Der nicht invertierende Eingang liegt an Masse. Der schnelle Pfad besteht ebenfalls aus einem Operationsverstärker, dessen nicht invertierendem Eingang das vom langsamen Pfad kommende Signal $U_x$ zugeführt wird. Der Ausgang dieses Operationsverstärkers ist über den Widerstand R5 an dem invertierenden Eingang zurückgeschaltet, dem wiederum der Widerstand R4 zugeschaltet ist. Vom Eingang $U_{e1}$ führt also eine Leitung zum Widerstand R4.

Die Übertragungsfunktion des Loopfilters A lautet:

$$S_A(p) = - \frac{R_2 + \frac{1}{pC_1}}{R_1} = - \frac{1 + pC_1 R_2}{pC_1 R_1} \qquad (1)$$

des Loopfilters B

$$U_x = U_{e1} * \frac{-1}{pC_2 R_3} \qquad (2)$$

$$U_{a2} = - \frac{R_5}{R_4} * (U_{e1} - U_x) + U_x \qquad (3)$$

$$U_{a2} = - U_{e1} * \left[ \frac{R_5}{R_4} + \frac{R_5 + R_4}{R_4} * \frac{1}{pC_2 R_3} \right] \qquad (4)$$

$$S_B(p) = \frac{U_{a2}}{U_{e1}} = - \frac{R_5 + R_4}{R_4} * \frac{1 + p * (R_3 * R_5 / R_5 + R_4) * C_2}{pC_2 R_3} \qquad (5)$$

Um die Übertragungsfunktion $S_A$ und $S_B$ ineinander überzuführen, wird über den Nenner der Gleichungen gefunden.

$$R_1 C_1 = \frac{R_3 * R_4}{R_5 + R_4} * C_2 \qquad (6)$$

und über den Zähler

$$R_2 C_1 = \frac{R_3 * R_5}{R_5 + R_4} * C_2 \qquad (7)$$

Es gibt unendlich viele Lösungsmöglichkeiten. Setzt man beispielsweise:

$$C_2 = C_1 \qquad (8)$$

$$R_4 = R_1 \qquad (9)$$

$$R_5 = R_2 \qquad (10)$$

So ergibt sich:

$$R_3 = R_4 + R_5 \qquad (11)$$

Somit sind beide Schaltungen, von den Klemmen aus gesehen, in elektrischer Hinsicht identisch. Der langsame Pfad ist ein Integrator mit der Integratorkonstante 1/(R3 * C2). In praktischen Anwendungen (z.B. Trägerrückgewinnungen) ist diese Konstante deutlich kleiner als die 3 dB-Bandbreite der gesamten Loop.

Damit war die Voraussetzung gegeben, die bewährte Auto-Zero-Technik nur im Integratorpfad einzusetzen, da hier das periodische, kurzzeitige Einblenden der Referenzfolge aufgrund der genügend langsamen Integrationsgeschwindigkeit nicht stört. Da der statische Regelrestfehler nur vom Offset des Integratorpfades bestimmt wird und dieser bei der beschriebenen Auto-Zero-Technik sehr klein ist, werden extrem kleine stationäre Phasenrestfehler der Regelschleife erreicht.

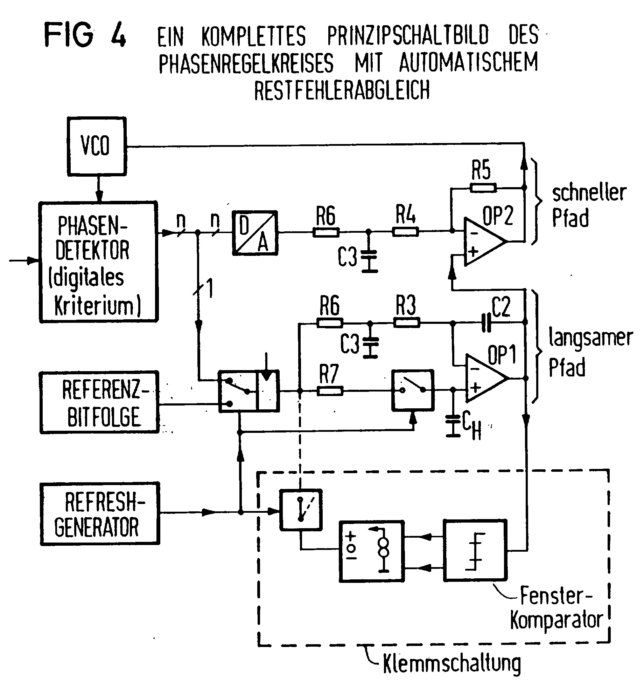

Figur 4 zeigt das komplette Prinzipschaltbild des Phasenregelkreises mit automatischem Restfehlerabgleich.

Zu erkennen sind die eingangs erläuterten Teilschaltungen. Die Unterteilung "schneller Pfad" und "langsamer Pfad" ist eingehalten. Dem schnellen Pfad ist ein Operationsverstärker OP2 und dem langsamen Pfad ein Operationsverstärker OP1 zugeordnet. Die einzelnen Schaltungsbestandteile wurden vorstehend beschrieben. Dem schnellen Pfad ist vorgeschaltet ein D/A-Wandler DA.. Zu erkennen ist der Phasendetektor (digitales Kriterium), die Referenzbitfolge, und ein Refreshgenerator. Weiterhin zugeordnet ist die gestrichelt eingerahmte Schaltung, die als Klemmschaltung bezeichnet ist. Diese Klemmschaltung enthält einen Fensterkomperator und eine gesteuerte Stromquelle. Der Ausgang des schnellen Pfades führt auf den spannungsgesteuerten Oszillator VCO. Der Ausgang des langsamen Pfades führt auf die Klemmschaltung und auf den Eingang des schnellen Pfades.

Figur 4 zeigt die Gesamtschaltung. Auf die Klemmschaltung wird im nächsten Abschnitt eingegangen. R6 und C3 dienen wieder zur Unterdrückung von hochfrequenten Störanteilen. Das Phasendetektorkriterium wird vom Ausgang eines Digitalbausteins abgenommen. Falls die Wortbreite des Detektorsignals mehr als ein Bit beträgt, wird nur das höchstwertige Bit dem langsamen Pfad zugeführt. Im schnellen Pfad kann dann die volle Wortbreite über einen D/A-Wandler in ein analoges Signal umgesetzt werden, was sich besonders günstig auf ein geringes Restregelrauschen und eine größere Unabhängigkeit der 3 dB-Bandbreite der Loop vom Signal-Störabstand auswirken kann.

Für die "Klemmschaltung" gilt folgendes:

Wie bereits erwähnt, ist bei klassischen Loops 2. Ordnung (Figur 1) im Rückkopplungspfad des Op-Amps der Widerstand R8 erforderlich, der allerdings bei Frequenzablagen statischen Regelrestfehler verursacht. Die ebenfalls eingezeichnete Klemmschaltung umgeht diesen Nachteil. Im Falle der nicht geschlossenen Schleife wird die Integrator-Ausgangsspannung versuchen, auf Anschlag zu laufen. Uber den Fensterkomparatur wird erkannt, ob diese Spannung vorher festgelegte Ober- und Untergrenzen übersteigt. Diese Grenzen legen den maximalen Frequenzfangbereich der Schaltung fest. Beim Ansprechen des Fensterkomparators wird über eine Stromquelle ein positiver oder negativer Klemmstrom in den Integrator gespeist. Dadurch wird verhindert, daß OP1 außerhalb seines Ausgangsspannungs-Betriebsbereich geraten kann. Beim Schließen der Schleife kann somit sofort der Frequenz-Einrastvorgang beginnen. Ein dem Widerstand R8 entsprechendes Schaltungselement ist somit in der gesamten Schaltung nicht erforderlich. Dadurch wird bei allen Frequenzablagen (des VCO's) die gleiche Restphasenfehlergenauigkeit erreicht, wie vorhergend beschrieben.

Die Klemmschaltung läßt sich, wenn nötig, auf einfache Weise zu einer Frequenzsuchlaufschaltung (Wobbler) erweitern, wenn bei Erreichen der beiden Schwellen des Fensterkomparators in Flipflop gesetzt, bzw. -rückgesetzt wird und der Ausgang des Flipflops den Kompensationsstrom festlegt. Vergleiche Anspruch 5.

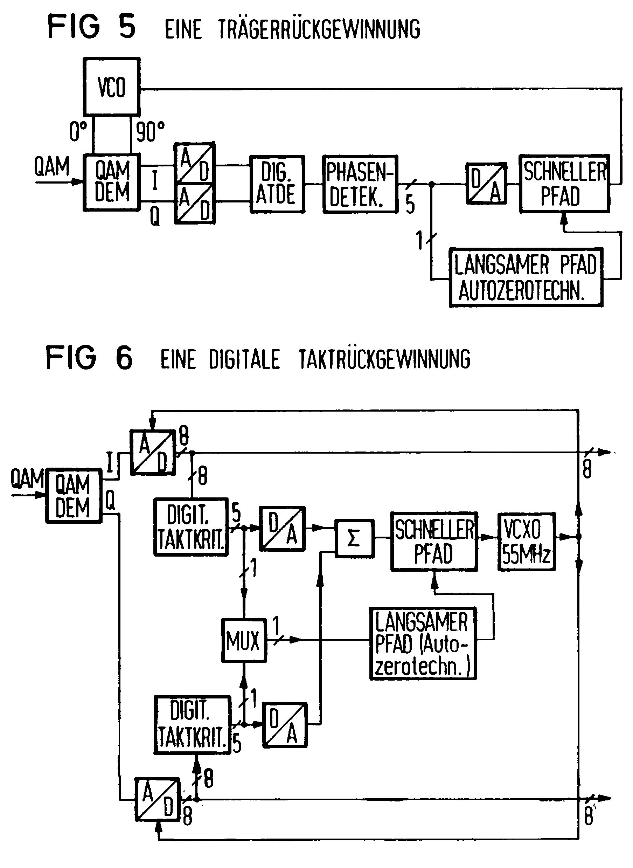

In den Figuren 5 und 6 sind Anwendungsbeispiele des Prinzips gezeigt, und zwar in Figur 5 ein Beispiel für die Trägerrückgewinnung und in Figur 6 ein Beispiel für die Taktrückgewinnung.

Vergleicht man die beiden Figuren mit vorstehend schon beschriebenen Figuren, ist sofort zu erkennen, daß in diesen beiden Anwendungsbeispielen frühere Bauteile verwendet werden. Es ist zu erkennen ein spannungsabhängiger Oszillator VCO mit dem 0° und dem 90°-Pfad, ein QAM-Demodulator, dem die Signale I und Q entnommen und anschließend auf A/D-Wandler gegeben werden, dort folgt ein digitaler Zeitbereichsentzerrer (ATDE) ein Phasendetektor und es wird anschließend unterteilt in den langsamen Pfad mit Auto-Zero-Technik und andererseits nach einem D/A-Wandler in den schnellen Pfad. Der Ausgang des schnellen Pfades führt auf den spannungsabhängigen Oszillator VCO.

Das Beispiel von Figur 6 zeigt eine Taktrückgewinnung. Wie in Figur 5 bedeuten dort Leitungen die schräg durchgestrichen sind, und die Ziffern n und 1-8 haben, daß es sich dort um Leitungen für einen Datenbus mit Bit n bzw. 1-8 Leitungen handelt.

Figur 6 zeigt also wiederum einen QAM-Demodulator mit den Signalen I und Q. Im Pfad I folgt ein A/D-Wandler, genauso im Pfad Q. In beiden Pfaden folgen Schaltungsteile, die digitale Taktkriterien liefern und schließlich wiederum D/A-Wandler. Über einen Multiplexer MUX der nur das höchst-wertige (1) des Datenbusses (5) verarbeitet, wird erreicht der "langsame Pfad (Auto-Zero--Technik)" und es wird vom unteren D/A-Wandler über einen Summierer $\Sigma$ der schnelle Pfad erreicht. Der schnelle Pfad steuert den Baustein VCXO (Voltage controlled x-tal oscillator), welcher wiederum den Takt für die A/D-Wandlung liefert.

Im folgenden wird noch beschrieben, eine Kombination des Auto-Zero-Prinzips mit (Sigma-Delta)-D/A-Wandlern.

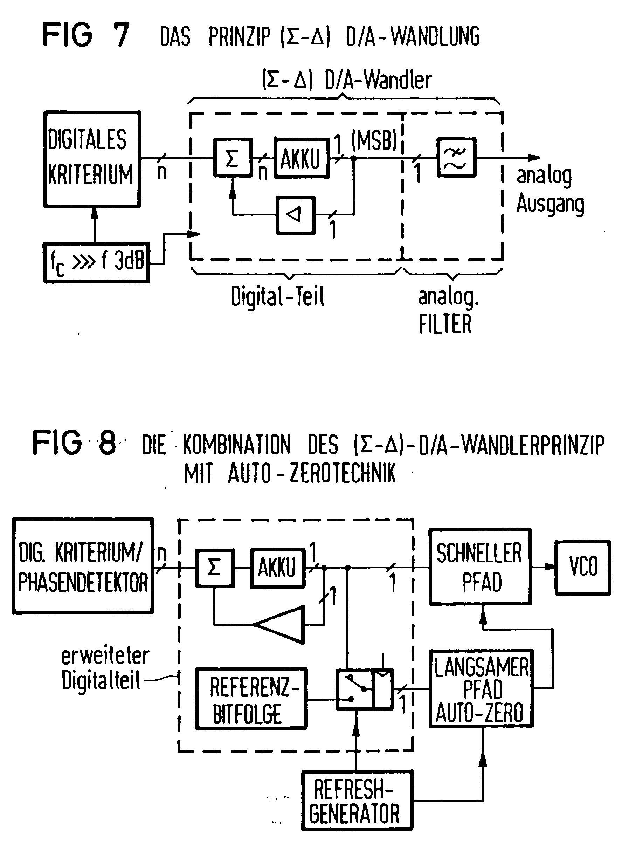

Figur 7 zeigt im Blockschaltbild das Prinzip der (Sigma-Delta)-D/A-Wandlung. Die Symbole wurden an früheren Figuren bereits erläutert. Erkennbar ist ein Schaltungsteil, das ein digitales Kriterium liefert und ein Taktgenerator (fc >>> f 3dB) dessen Frequenz $f_c$ wesentlich höher als die 3dB-Grenzfrequenz des nachfolgenden analogen Tiefpasses ist. Der gesamte (Sigma-Delta)-D/A-Wandler ist unterteilt in ein digitales Teil und ein analoges Filter (Tiefpaß), mit einem analogen Ausgang. Der digitale Teil enthält den Summierer Σ, dem ein Akkumulator (Akku) folgt und dessen höchstwertigstes Bit (MSB) zum Summierer (Σ) zurückgeführt wird und in den Eingang des analogen Tiefpasses geleitet wird.

Falls das Phasen-Detektorsignal eine Wortbreite von mehreren Bits aufweist und gleichzeitig ein sehr großer Frequenzabstand zwischen höchster Ubertragungsfrequenz und Taktfrequenz vorliegt, kann bei den vorher beschriebenen Träger- und Taktrückgewinnungsschaltungen (Figur 5, 6) anstelle eines n-bit breiten D/A-Wandlers vorteilhaft das (Sigma-Delta)-Prinzip angewendet werden. Bei den Beispielen ist das der Fall.

Das Prinzip der (Sigma-Delta)-D/A-Wandlung ist in Figur 7 dargestellt. Das mehrstufige Ausgangssignal des digitalen Kriteriums, bzw. des Phasendetektors wird in den Digitalteil des (Sigma-Delta)-Wandlers gespeist. Der Ausgang des Digitalteils hat nur 1-bit Wortbreite. Aufgrund der speziellen Schaltung sind jedoch die Spektralanteile des durch die 1-bit Quantisierung entstehenden Geräusches bei niedrigen Frequenzen sehr gering, so daß nach dem nachfolgenden analogen Tiefpaß, der seinerseits die starken hochfrequenten Anteile unterdrückt, ein sehr geringes Restrauschen übrigbleibt.

Bei Anwendungen des (Sigma-Delta)-Prinzips läßt sich der Digitalteil problemlos als Zusatzfunktion in einem digitalen Baustein realisieren und das Ausgangssignal benötigt aann nur einen einzigen Pin und keinen zusätzlichen D/A-Wandler.

Eine Kombination des (Sigma-Delta)-D/A-Wandlerprinzips mit Auto-Zero-Technik ist in Figur 8 dargestellt. Wie in früheren Figuren ist erkennbar ein digitales Kriterium/Phasendetektor, es folgt gestrichelt eingerahmt, ein erweiterter Digitalteil, dem sich der "schnelle Pfad" anschließt. An dessen Ausgang liegt der VCO. Der erweiterte Digitalteil ist vergleichbar mit Figur 7 enthält jedoch zusätzlich den Schaltungsabschnitt "Referenzbitfolge" sowie einen Schalterbaustein. Vom Ausgang des Schalterbausteins wird der "langsame Pfad, Auto-Zero-Pfad" erreicht. Enthalten ist ein "Refreshgenerator" der einerseits zum Schalterbaustein führt und andererseits zum "langsamen Pfad, Auto-Zero". Der Ausgang des langsamen Pfades führt auf einen weiteren Eingang des "schnellen Pfades".

Da der Gleichstrom-Mittelwert des höchstwertigsten Bits (MSB) des Digitalteils des ($Σ - Δ$)-DA Wandlers von dem physikalischen Logikpegel dieses Signals abhängig ist würde das in den betrachteten Phasenregelkreisen zu Offset und damit zu Regelrestfehlern führen. Doch dieser Nachteil läßt sich durch zusätzliche Einführung der Auto-Zero-Technik eliminieren. Figur 8 zeigt das Prinzipschaltbild.

Der Digitalteil muß dadurch nur geringfügig erweitert werden und ein zusätzlicher Ausgang für den langsamen Pfad muß vorgesehen sein.

Die Schaltung kombiniert in nahezu perfekter Weise die Vorteile des (Sigma-Delta)-Wandlungsprinzips mit denen der Auto-Zero-Selbstabgleichtechnik bei semi-digital realisierten Phasenregelkreisen besonders bei Takt- und Trägerrückgewinnung in QAM-Richtfunksystemen mit hoher Modulationsstufenzahl, bzw. hoher Bandbreiteneffizienz.

## Patentansprüche

1. Phasenregelkreis höherer Odrnung (Fig. 1) mit automatischem Restfehlerabgleich, bestehend aus einem Phasendetektor, der ein digitales (binäres) Fehlerkriterium am Regelziel aufweist, sowie einem spannungsgesteuerten Oszillator (VCO), einem Schleifenfilter (LF) und aus einer Selbstabgleich-Einrichtung,
   **dadurch gekennzeichnet**,
   daß das Schleifenfilter des Phasenregelkreises in einen langsamen (Integrator-) Pfad und einen schnellen Pfad zerlegt wird und daß die an sich bekannte Auto-Zero-Selbstabgleichtechnik nur in den Integratorpfad eingebracht ist, derart daß eine Referenzbitfolge, die den gleichen physikalischen Gleichspannungsmittelwert wie eine Ergebnisbitfolge mit zufallsartiger Verteilung von Einsen und Nullen aufweist, periodisch auf einen Haltekondensator ($C_H$) geschaltet wird,
   der unmittelbar am Referenzspannungseingang des Integrator-Operationsverstärkers (+, -) geschaltet wird (Fig. 2, 3A, 3B, 4).

2. Phasenregelkreis nach Anspruch 1,
   **dadurch gekennzeichnet**,
   daß die Schaltelemente des zeriegten Schleifenfilters derart gewählt sind, daß die Beziehungen gelten:

$$R_1\, C_1 = \frac{R_3 * R_4}{R_5 + R_4} * C_2 \qquad \text{und} \qquad (6)$$

$$R_2 C_1 = \frac{R_3 * R_5}{R_5 + R_4} * C_2, \qquad (7)$$

dabei bedeuten,

R$_1$ — den Vorwiderstand vor dem invertierenden Eingang des Operationsvestärkers, (bei nicht zerlegter Dimensionierung)

R$_2$, C$_1$ — die Serienschaltung im Rückkopplungspfad des Operationsverstärkers (bei nicht-zerlegter Dimensionierung),

R$_3$, C$_2$ — die die Integrationszeit bestimmenden Schaltelemente des Integrator-pfades (bei zerlegter Dimensionierung),

R$_4$, R$_5$ — die die Verstärkung des schnellen Pfades bestimmenden Schaltelemente (bei zerlegter Dimensionierung),

und daß der Ausgang des Integratorpfades auf den nicht-invertierenden Eingang des Operationsverstärkers des schnellen Pfades geschaltet wird (Fig. 3B).

3. Phasenregelkreis nach Anspruch 1 oder 2,
   **dadurch gekennzeichnet**,
   daß ein ($\Sigma$-$\Delta$) D/A-Wandler an den n-bit breiten Ausgang des Phasendetektors (digitales Kriterium) geschaltet ist, und daß der 1-bit breite Ausgang des ($\Sigma$-$\Delta$) D/A Wandlers auf zwei Pfade aufgespalten wird (schneller/langsamer Pfad) und dabei die Selbst-Abgleich-Einrichtung (Auto-Zero-Einrichtung) nur im langsamen Pfad vorgesehen ist (Fig. 7, 8).

4. Phasenregelkreis nach einem der vorhergehenden Ansprüche
   **dadurch gekennzeichnet**,
   daß (zur Vermeidung von Offset aufgrund von Frequenzablage des empfangenen Signals) der Ausgang des langsamen Pfades mit Hilfe eines Fensterkomparators auf Maximal- und Minimal-Spannungen, die im linearen Betriebsbereich des Operationsverstärkers (OP1) liegen, überwacht wird und damit einen positiven oder negativen Kompensationsstrom in den Eingang des langsamen Pfades einprägt, so daß
   selbst bei augerastetem Regelkreis der im langsamen Pfad liegende Operationsverstärker (OP1) im linearen Arbeitsbereich bleibt, und dabei der Kompensationsstrom bei Anliegen der Referenzbitfolge unterbrochen wird.

5. Phasenregelkreis nach Anspruch 4,
   **dadurch gekennzeichnet**,
   daß bei Erreichen der beiden Schwellen des Fensterkomparators ein Flipflop gesetzt, bzw.- rückgesetzt wird und der Ausgang des Flipflops die Richtung des Kompensationsstromes festlegt, wodurch eine Frequenzwobbelfunktion erreicht wird.

**Claims**

1. Higher order phase-locked loop (Figure 1) having automatic residual error compensation, consisting of a phase detector which has a digital (binary) error criterion at the control target, and a voltage-controlled oscillator (VCO), a loop filter (LF) and of a self-compensating device, characterised in that the loop filter of the phase-locked loop is broken down into a slow (integrator) path and a fast path, and in that the autozero self-compensating technique known per se is introduced only into the integrator path in such a way that a reference bit sequence, which has the same physical d.c. voltage mean as a result bit sequence with quasi-random distribution of ones and zeros, is periodically switched to a hold capacitor (C$_H$) which is connected directly at the reference voltage input of the integrator-operational amplifier (+, -) (Figures 2, 3A, 3B, 4).

2. Phase-locked loop according to Claim 1, characterised in that the circuit elements of the broken down loop filter are chosen such that the relationships hold that:

$$R_1 C_1 = \frac{R_3 * R_4}{R_5 + R_4} * C_2 \qquad \text{and} \qquad (6)$$

$$R_2 \, C_1 = \frac{R_3 * R_5}{R_5 + R_4} * C_2,$$ (7)

where

R$_1$    signifies the series resistor before the inverting input of the operational amplifier (for dimensioning that is not broken down),

R$_2$, C$_1$    signify the series circuit in the feedback path of the operational amplifier (for dimensioning that is not broken down),

R$_3$, C$_2$    signify the circuit elements of the integrator path which determine the integration time (for dimensioning that is not broken down),

R$_4$, R$_5$    signify the circuit elements determining the gain of the fast path (for dimensioning that is not broken down),

and in that the output of the integrator path is connected to the non-inverting input of the operational amplifier of the fast path (Figure 3B).

3.    Phase-locked loop according to Claim 1 or 2, characterised in that a ($\Sigma$ - $\Delta$) D/A converter is connected to the n-bit wide output of the phase detector (digital criterion), and in that the 1-bit wide output of the ($\Sigma$ - $\Delta$) D/A converter is subdivided into two paths (fast/slow path) and in this arrangement the self-compensating device (autozero device) is provided only in the slow path (Figures 7, 8).

4.    Phase-locked loop according to one of the preceding claims, characterised in that (in order to avoid offset due to frequency deviation of the received signal) the output of the slow path is monitored with the aid of a window comparator for maximum and minimum voltages, which are located in the linear operating range of the operational amplifier (OP1), and thus applies a positive or negative compensation current to the input of the slow path, so that even in the case of an unlocked control loop the operational amplifier (OP1) located in the slow path remains in the linear operating range, and in the process the compensation current is interrupted upon application of the reference bit sequence.

5.    Phase-locked loop according to Claim 4, characterised in that a flipflop is set or reset when the two thresholds of the window comparator are reached, and the output of the flipflop fixes the direction of the compensation current, as a result of which a frequency wobble function is achieved.

**Revendications**

1.    Boucle à verrouillage de phase d'ordre grand (figure 1) à équilibrage automatique d'erreurs résiduelles, constituée d'un détecteur de phase, qui a pour but de régulation un critère numérique (binaire) d'erreur, ainsi que d'un oscillateur (VCO) commandé par tension, un filtre (LF) de boucle et un dispositif d'équilibrage automatique, caractérisée en ce que le filtre de la boucle à verrouillage de phase se compose d'une voie lente (intégratrice) et d'une voie rapide, la technique d'équilibrage automatique connue en soi auto-zéro n'est utilisée que dans la voie intégratrice, de sorte qu'un train de bits de référence, qui a la même valeur moyenne physique de tension continue qu'un train de bits de résultat à répartition aléatoire de uns et de zéros soit appliqué périodiquement à un condensateur (C$_H$) de maintien, qui est branché directement à l'entrée de tension de référence de l'amplificateur opérationnel intégrateur (+, -) (figures 2, 3A, 3B, 4).

2.    . Boucle à verrouillage de phase suivant la revendication 1, caractérisée en ce que les éléments du circuit du filtre de boucle décomposé sont choisis de sorte à vérifier les relations :

$$R_1 \, C_1 = \frac{R_3 * R_4}{R_5 + R_4} * C_2 \qquad \text{et}$$ (6)

$$R_2 \, C_1 = \frac{R_3 * R_5}{R_5 + R_4} * C_2,$$ (7)

où R$_1$ est la résistance en amont de l'entrée inverseuse de l'amplificateur opérationnel (pour une structure non décomposée),

$R_2$, $C_1$ étant le circuit série dans la voie de rétroaction de l'amplificateur opérationnel (dans le cas de la structure non décomposée),

$R_3$, $C_2$ étant les éléments déterminants le temps d'intégration du circuit de la voie intégratrice (dans le cas de la structure décomposée),

$R_4$ et $R_5$ étant les éléments du circuit déterminant l'amplification de la voie rapide (dans le cas de la structure décomposée),

et la sortie de la voie intégratrice est branchée à l'entrée non inverseuse de l'amplificateur opérationnel de la voie rapide (figure 3B).

3. Boucle à verrouillage de phase suivant la revendication 1 ou 2, caractérisée en ce qu'un convertisseur numérique/analogique ($\Sigma$ - $\Delta$) est branché à la sortie, d'une largeur de n bits, du détecteur de phase (critère numérique), et la sortie, d'une largeur de 1 bit, du convertisseur numérique/analogique ($\Sigma$ - $\Delta$) est divisée en deux voies (voie rapide/voie lente) et le dispositif d'équilibrage automatique (dispositif auto-zéro) n'est prévu que dans la voie lente (figures 7, 8).

4. Boucle à verrouillage de phase suivant l'une des revendications précédentes, caractérisée en ce que les tensions maximum et minimum, qui sont dans la zone de fonctionnement linéaire de l'amplificateur opérationnel (OP1), de la sortie de la voie lente, sont contrôlées à l'aide d'un comparateur de fenêtre (pour empêcher un décalage du fait de la dérive de fréquence du signal reçu) et appliquent ainsi un courant positif ou négatif de compensation à l'entrée de la voie lente, de sorte que même lorsque la boucle à verrouillage est déverrouillée l'amplificateur opérationnel (OP1) se trouvant dans la voie lente reste dans la zone de fonctionnement linéaire et qu'en l'occurrence les courants de compensation soient interrompus lorsqu'on applique le train de bits de référence.

5. Boucle à verrouillage de phase suivant la revendication 4, caractérisée en ce que lorsque les deux seuils du comparateur à fenêtre sont atteints, une bascule est positionnée ou remise à l'état initial et la sortie de la bascule fixe la direction du courant de compensation, ce qui permet d'obtenir une fonction de balayage de fréquence.

## FIG 1  EIN PHASENREGELKREIS 2.ORDUNG, STANDARD-SCHALTUNG

$K_0$ : Oszillator - Konstante

$K_D$ : Detektor - Konstante

T : Tot - Zeit des Kreises

LF : Loop - Filter

TP : Vorschalt - Tiefpass

(kann für Übertrag. fkt. i. a.

vernachlässigt werden)

## FIG 2  EINE KOEFFIZIENTEN MIT AUTO-ZERO-TECHNIK

## FIG 3A  EIN KLASSISCHES LOOPFILTER FÜR PHASENREGELKREIS 2. ORDNUNG

## FIG 3B  EINE "ZERLEGTE" STRUKTUR DES LOOPFILTERS

## FIG 4 EIN KOMPLETTES PRINZIPSCHALTBILD DES PHASENREGELKREISES MIT AUTOMATISCHEM RESTFEHLERABGLEICH

## FIG 5 EINE TRÄGERRÜCKGEWINNUNG

## FIG 6 EINE DIGITALE TAKTRÜCKGEWINNUNG

## FIG 7 DAS PRINZIP (Σ-Δ) D/A-WANDLUNG

(Σ-Δ) D/A-Wandler

DIGITALES KRITERIUM

n

Σ

n

AKKU

1 (MSB)

◁

1

1

≈

analog Ausgang

$f_c \ggg f$ 3dB

Digital-Teil

analog. FILTER

## FIG 8 DIE KOMBINATION DES (Σ-Δ)-D/A-WANDLERPRINZIP MIT AUTO-ZEROTECHNIK

DIG. KRITERIUM/ PHASENDETEKTOR

n

Σ

AKKU

1

1

1

SCHNELLER PFAD

VCO

erweiteter Digitalteil

REFERENZ- BITFOLGE

1

LANGSAMER PFAD AUTO-ZERO

REFRESH- GENERATOR